Europäisches Patentamt

European Patent Office

Office européen des brevets

(11) Numéro de publication: **0 236 200**
**A1**

## (12) DEMANDE DE BREVET EUROPEEN

(21) Numéro de dépôt: **87400325.4**

(22) Date de dépôt: **13.02.87**

(51) Int. Cl.⁴: **H 01 L 29/06**
    H 01 L 27/02

(30) Priorité: **18.02.86 FR 8602181**

(43) Date de publication de la demande:
**09.09.87 Bulletin 87/37**

(84) Etats contractants désignés: **DE FR GB IT NL**

(71) Demandeur: **THOMSON-CSF**
**173, Boulevard Haussmann**
**F-75379 Paris Cedex 08 (FR)**

(72) Inventeur: **Quoirin, Jean-Baptiste THOMSON-CSF**
**SCPI-19, avenue de Messine**
**F-75008 Paris (FR)**

**Nadd, Bruno THOMSON-CSF**
**SCPI-19, avenue de Messine**
**F-75008 Paris (FR)**

**Mille, Jacques THOMSON-CSF**
**SCPI-19, avenue de Messine**
**F-75008 Paris (FR)**

(74) Mandataire: **Guérin, Michel et al**
**THOMSON-CSF SCPI'19, avenue de Messine**
**F-75008 Paris (FR)**

(54) Structure semiconductrice associant un ou plusieurs transistors de puissance, et leur logique de commande et de protection.

(57) La présente invention concerne des structures semiconductrices associant un ou plusieurs transistors de puissance et leur partie logique ou analogique de commande et de protection, notamment celles désignées sous l'appellation de commutateur de puissance intelligent.

L'invention a pour objet l'isolation électrostatique entre la partie logique ou analogique et la partie de puissance associées sur la même structure, un autoblindage de la partie logique étant assuré grâce à une disposition particulière des caissons contenant la logique (11, 12) et la partie de puissance (10) et grâce à des anneaux périphériques (13, 14) entourant ces caissons.

FIG_2

EP 0 236 200 A1

## Description

### STRUCTURE SEMICONDUCTRICE ASSOCIANT UN OU PLUSIEURS TRANSISTORS DE PUISSANCE ET LEUR LOGIQUE DE COMMANDE ET DE PROTECTION.

La présente invention concerne une structure semiconductrice associant un ou plusieurs transistors de puissance et leur logique de commande et de protection. Cette structure peut encore être désignée sous l'appellation "commutateur de puissance intelligent".

Les applications croissantes de l'électronique à tous les secteurs industriels conduisent à une multiplication des longueurs de câbles électriques. En particulier dans les automobiles, le câblage électrique des différents organes est de plus en plus complexe, chacun d'eux étant pratiquement commandé individuellement. D'une manière générale, ce câblage se fait sous la forme d'un faisceau de fils de plus en plus volumineux dont le contrôle et le dépannage après montage sont pratiquement impossibles. La solution à ce problème réside en l'utilisation du multiplexage. Chaque accessoire ayant la faculté de reconnaître l'information qui le concerne, on peut donc relier tous ces accessoires par un même fil de commande. Un tel type de multiplexage conduit à l'association sur un même substrat d'un ou plusieurs transistors de puissance et de leur logique de commande et de protection. Cette association pose des problèmes délicats pour le fonctionnement du circuit logique et analogique associé au transistor de puissance. En particulier, si le transistor de puissance est à structure verticale du type VDMOS ou bipolaire et qu'il est à l'état bloqué, les tensions présentes aux bornes de ce transistor peuvent avoir des répercussions fâcheuses sur le circuit logique et analogique associé. Il est alors essentiel d'isoler la structure logique et analogique de la structure de puissance.

Il est connu d'assurer l'isolement de ces structures par un écran physique. C'est la solution qui s'impose à l'évidence et c'est même la seule qui semble possible. Elle est utilisée dans tous les dispositifs connus. Son choix est d'autant plus motivé que l'élaboration de ces structures suit des règles parfaitement connues. Les réalisations actuelles de ces structures se distinguent par la façon de réaliser cet écran physique en fonction de la configuration (horizontale ou verticale) retenue pour le circuit de puissance. Les solutions actuellement proposées sont de trois types. L'isolement peut être assuré par une ou plusieurs jonctions polarisées en inverse en configuration horizontale ou verticale. De telles structures ont été proposées notamment par SGS Semiconductor et par Motorola et sont décrites dans l'article "Power devices are in the chips" paru dans la revue IEEE Spectrum de juillet 1985, pages 42-48. L'isolement peut encore être assuré par un diélectrique.

L'écran physique est la solution qui vient tout de suite à l'esprit parce qu'elle assure un découplage complet entre partie logique et partie de puissance. Cependant, cette solution comporte plusieurs inconvénients sérieux. Certaines réalisations exigent, pour une utilisation sous haute tension, une épitaxie sur couche enterrée qui implique la répétition de certaines séquences. Leur mise en oeuvre implique un grand nombre de niveaux de masquage (supérieur ou égal à 12) croissant avec la valeur de la tension à tenir, ce qui entraîne un prix de revient élevé. Un autre inconvénient majeur des solutions à écran physique est de proposer une technologie dont les séquences de réalisation sont à modifier profondément chaque fois que l'on change de domaine de tension. C'est donc une filière technologique rigide et complexe. L'application aux moyennes et hautes tensions est difficile.

Afin de pallier ces inconvénients, l'invention propose un isolement électrostatique. Ce type d'isolement n'avait pas jusqu'ici été considéré parce que, a priori, il semble remettre en cause la qualité de l'isolement. En effet, du fait de la proximité des structures logique et de puissance, on réalise un couplage partiel entre partie logique et partie de puissance, ce qui semble aller à l'encontre du but recherché. Cette solution s'impose d'autant moins qu'elle implique l'établissement de règles de dessin spéciales pour la topographie du circuit. Parmi les avantages apportés par l'invention, on relève ce qui suit. L'invention permet une épitaxie standard de type N sur un substrat N+ beaucoup plus simple à réaliser qu'une épitaxie sur couche enterrée. Elle permet de réaliser la partie de puissance selon une configuration verticale valable pour toutes tensions. Elle implique un nombre restreint de niveaux de masquages (inférieur ou égal à 11) et qui est proche de celui d'une structure de puissance. Enfin, c'est une filière technologique souple et simple qui permet une généralisation aisée vers les structures hautes tensions.

L'invention a donc pour objet une structure semiconductrice associant au moins un transistor de puissance et une partie logique ou analogique sur un même substrat semiconducteur, le transistor de puissance étant du type MOS vertical à contact de drain sur la face arrière du substrat ou du type bipolaire vertical à contact de collecteur sur la face arrière du substrat ou une combinaison des deux types, la partie logique ou analogique étant du type à transistors MOS réalisée sur la face avant du substrat et destinée à commander la conduction du transistor de puissance, caractérisée en ce que :

- le substrat est de type N+ fortement dopé,

- le substrat est recouvert d'une ou de plusieurs couches épitaxiales ininterrompues de type N peu dopée,

- des régions de type P sont diffusées à partir de la couche épitaxiale jusqu'à des profondeurs inférieures à celle de cette couche épitaxiale, ces régions définissant des caissons notamment pour des transistors MOS à canal N et des régions de canal ou de base pour le transistor de puissance,

- la distance séparant deux régions de type P adjacentes étant inférieure à la somme des largeurs des zones de charge d'espace engendrées dans le substrat autour de ces régions de type P pour une tension entre région de type P et substrat qui risquerait de provoquer un claquage en surface ou en volume de la jonction existant entre la région de type P et le substrat et polarisée en inverse,

- l'ensemble des régions P diffusées étant entouré par une région périphérique de type P diffusée, la distance séparant cette région périphérique de l'ensemble des régions P diffusées étant déterminée par les mêmes critères qui servent à définir la distance séparant deux régions de type P adjacentes.

L'invention prévoit aussi l'utilisation d'écrans électrostatiques conducteurs ou électrodes de champ pour prolonger électrostatiquement certaines régions diffusées.

La partie logique peut comporter différents types de transistors MOS et notamment l'association d'un transistor MOS à déplétion et d'un transistor MOS enrichi.

L'invention sera mieux comprise et d'autres avantages apparaîtront au moyen de la description qui va suivre et des figures annexées parmi lesquelles :

    - la figure 1 représente une structure semiconductrice associant un transistor de puissance et un transistor de logique,

    - la figure 2 représente une structure semiconductrice où les conditions de l'invention sont respectées,

    - la figure 3 représente une structure semiconductrice où les conditions de l'invention ne sont pas respectées,

    - la figure 4 représente un détail d'une structure selon l'invention,

    - la figure 5 représente un détail d'une variante d'une structure selon l'invention,

    - la figure 6 représente une structure selon l'invention pouvant commander plusieurs charges,

    - la figure 7 représente une structure semiconductrice selon l'invention.

L'intégration d'une partie logique ou analogique de commande ou de protection sur un même substrat de silicium que celui sur lequel est constitué un transistor de puissance se heurte à des problèmes d'isolation entre les étages logique ou analogique et de puissance. Les différentes solutions proposées actuellement (isolement par jonction ou par diélectrique) présentent les inconvénients explicités plus haut. L'inconvénient principal de toutes ces solutions est de proposer une technologie dont les séquences de réalisation sont à modifier profondément chaque fois que l'on change de domaine de tension d'utilisation. Par exemple, dans le cas de l'isolement par jonction, les séquences technologiques pour une structure basse tension (de l'ordre de 60 volts) peuvent être les suivantes :

- première séquence : croissance par épitaxie d'une couche P sur un substrat N+,

- deuxième séquence : oxydation, gravure puis implantation par de l'arsenic de la couche enterrée localisée,

- troisième séquence : croissance par épitaxie d'une couche N uniforme,

- quatrième séquence : gravure, implantation de caissons d'isolement P+ puis recuit des caissons d'isolement P+ pour former une jonction avec la couche enterrée.

Pour une structure devant supporter une tension d'utilisation plus élevée (supérieure à 120 volts), la couche épitaxiée N déposée pendant la troisième séquence doit être plus épaisse ainsi bien sûr que les caissons d'isolement qui doivent traverser cette couche de type N. Il n'est pas possible de réaliser la quatrième séquence en jouant simplement sur les paramètres temps et température parce qu'alors on provoquerait la remontée de la couche enterrée N+, ce qui réduirait l'épaisseur de la couche N épitaxiée au-dessus de la couche enterrée. Pour pallier cet inconvénient, il faut reproduire successivement les séquences 3 et 4 autant de fois que nécessaire. On voit ainsi toute la complexité de mise en oeuvre de cette technologie.

La solution proposée par l'invention et qui assure un autoblindage de la partie logique ou analogique permet d'éviter cette mise en oeuvre complexe.

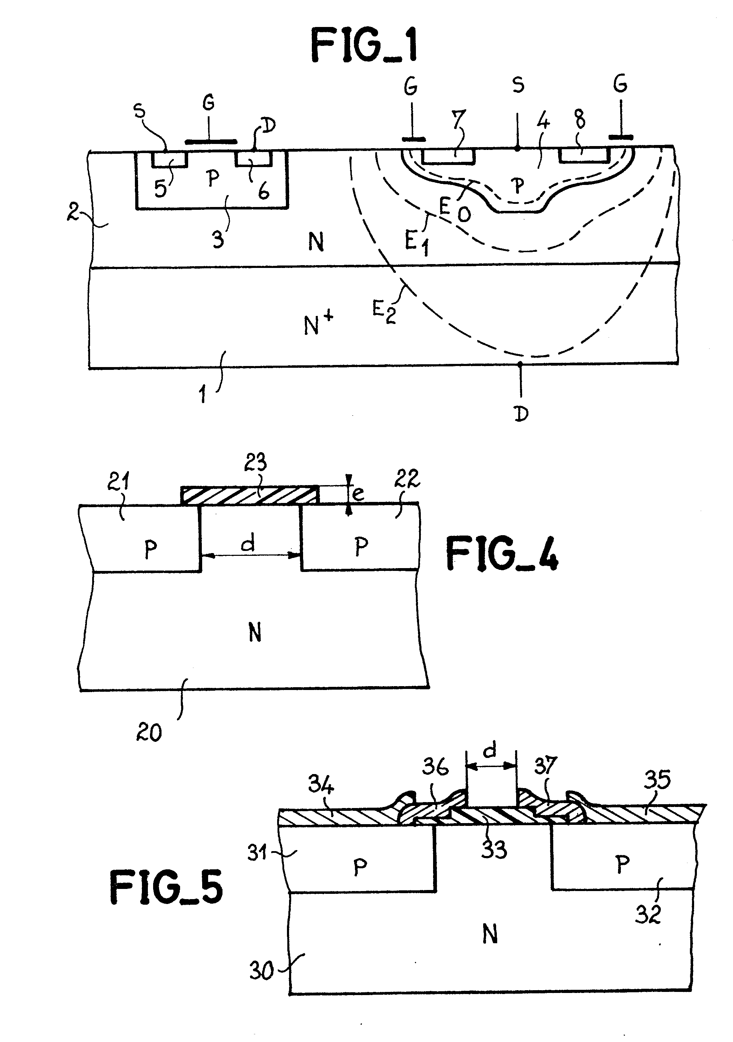

La figure 1 représente d'une façon théorique une structure semiconductrice associant un transistor de puissance et un transistor devant assurer une fonction logique. Le transistor de puissance est du type VD MOS et le transistor de la logique du type MOS à canal N. Sur un substrat en silicium 1 de type N+ on a déposé par épitaxie une couche 2 de type N, puis on a réalisé par implantation des caissons 3 et 4 de type P. D'autres implantations ont permis l'obtention de régions N+ référencées 5, 6, 7 et 8 dans les caissons P. Les prises de contact constituées par les régions 5 et 6 forment respectivement la source S et le drain D du MOS de la logique et une grille G déposée sur une couche d'isolant non représentée complète le transistor. La partie de droite de la figure représente le VD MOS avec son drain D situé sur la face arrière du substrat 1, sa source S et sa grille G situées sur la face avant. Plusieurs équipotentielles ont été tracées pour une haute tension V appliquée sur le drain du VD MOS et un potentiel de grille nul. L'équipotentielle $E_0$ est celle du potentiel nul. L'équipotentielle $E_1$ est celle correspondant à une tension $V_1$ et l'équipotentielle $E_2$ correspond à la tension V appliquée sur le drain. On voit que les tensions appliquées au transistor de puissance peuvent perturber le fonctionnement d'un transistor de la logique. Pour un fonctionnement correct de la partie logique, il faut que la tension appliquée sur le drain n'influe pas sur la région où est logée la partie logique. Les zones de la couche épitaxiale 2 situées entre les caissons P sont des zones à fortes courbures des équipotentielles. Dans ces zones, on risque un claquage en volume de la couche épitaxiale. Il faut que les équipotentielles correspondant à la haute tension soient repoussées à l'intérieur du volume de silicium sans remonter à la surface de la face avant du substrat au voisinage de la logique. Une telle situation peut être obtenue selon l'invention en réalisant simultanément deux configurations géométriques qui assurent une isolation électrostatique ou un blindage de la partie logique.

L'une de ces configurations est une structure distincte des structures logique et de puissance. Elle est localisée à la périphérie de l'ensemble des structures logique et de puissance. Il est avantageux qu'elle entoure sans discontinuité et totalement cet ensemble. Cette configuration est conçue selon les règles qui permettent la tenue en tension d'une jonction planar. Elle peut se présenter par exemple comme un anneau diffusé ou un ensemble d'anneaux. La distance séparant ces anneaux entre eux et la distance séparant l'ensemble des structures logique et de puissance sont déterminées par les règles de l'art connu.

La seconde configuration géométrique est constituée par la disposition relative des transistors logiques et de puissance entre eux d'une part et par rapport à la structure périphérique d'autre part. Ces éléments sont séparés par des remontées du matériau de drain (ou du collecteur le cas échéant) de la partie puissance. Plusieurs paramètres doivent être considérés pour caractériser ces remontées inter-composants : la distance $d$ séparant chaque composant et la qualité de l'isolement de surface entre les composants (oxyde, oxyde et silicium polycristallin, oxyde et métallisation en aluminium, etc.). On peut alors définir en fonction de la nature de l'isolement de surface, la largeur $d$ nécessaire pour éviter la remontée des équipotentielles dues à la haute tension. La valeur de la largeur $d$ dépend de chaque cas d'application, mais elle doit être inférieure à la somme des largeurs des zones de charge d'espace engendrées dans le substrat autour de deux caissons adjacents pour une tension entre caisson et substrat qui risquerait de provoquer un claquage en surface ou en volume de la jonction existant entre caisson et substrat et polarisée en inverse. Pratiquement, la largeur $d$ sera de l'ordre de la profondeur d'un caisson. La nature de l'isolement entre les composants doit être choisie de manière à éviter l'apparition d'une couche d'inversion à la surface (MOS parasite) qui mettrait en court-circuit deux composants distincts. Le calcul exact de la distance $d$ fait appel aux règles de l'art connu (résolution de l'équation de Poisson à 2 ou 3 dimensions) de même que les caractéristiques de la structure de l'isolement inter-composants.

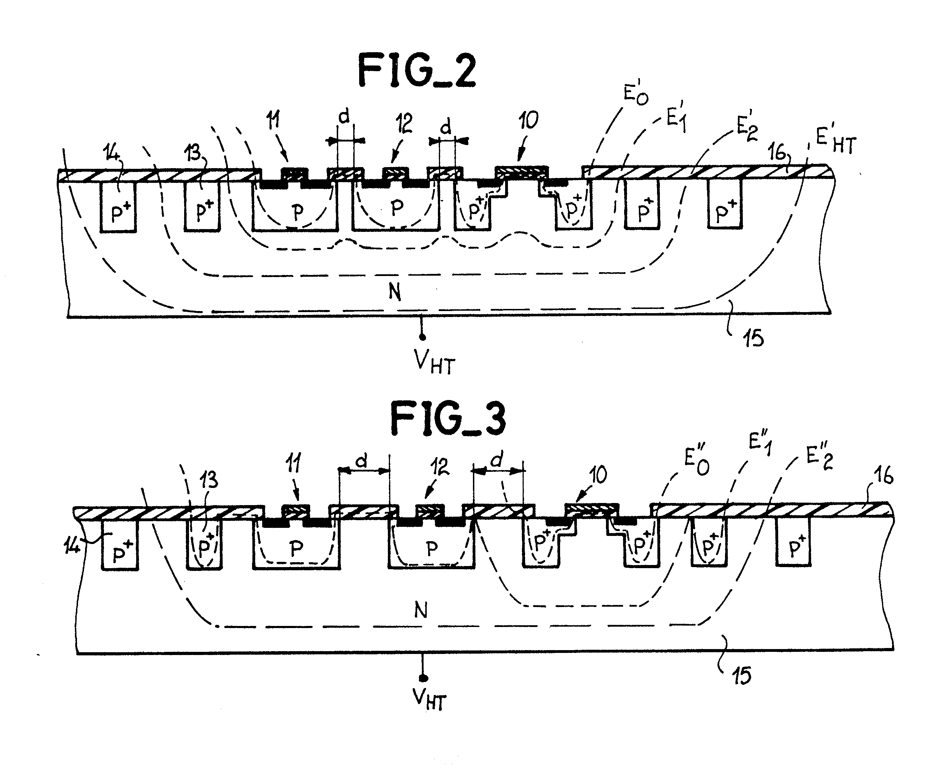

La figure 2 représente une structure semiconductrice développée sur un substrat de silicium et associant un transistor de puissance désigné par la référence générale 10 et une partie logique à deux transistors MOS référencés 11 et 12. Ces transistors ont été élaborés à partir de caissons de type P diffusés dans un substrat 15 de type N. Deux anneaux périphériques 13 et 14 de type P ont également été diffusés autour de l'ensemble constitué par les parties logique et de puissance. La couche hachurée 16 est une couche d'isolation constituée par exemple d'oxyde de silicium $SiO_2$. Les zones noircies sont des diffusions de type N+ et les couches d'oxyde de grille sont recouvertes de dépôts de silicium polycristallin.

Si les distances $d$ ont été correctement définies, les transistors de la partie logique se trouvent à l'intérieur de l'équipotentielle 0 volt lorsque la haute tension $V_{HT}$ est appliquée au drain du VD MOS de puissance situé sur la face arrière du substrat. Cette équipotentielle 0 volt est représentée par la ligne en pointillés $E'_0$. Les équipotentielles $E'_1$ et $E'_2$ représentent des équipotentielles de valeurs croissantes jusqu'à l'équipotentielle $E'_{HT}$ correspondant à la tension drain.

On a en quelque sorte réalisé un autoblindage de la partie logique. Les distances $d$ séparant les différents transistors ne sont pas nécessairement égales entre elles. Il faut simplement qu'elles ne dépassent pas une valeur limite déterminée par la résolution des équations de Poisson.

La figure 3 représente une structure analogue à celle de la figure 2, mais pour laquelle les distances $d$ dépassent la valeur limite admissible. L'équipotentielle $E''_0$ correspond à la valeur 0 volt. Les équipotentielles $E''_1$ et $E''_2$ ont été tracées pour des valeurs croissantes de tension. Du fait du mauvais ajustement des distances $d$, il y a une remontée des équipotentielles dans la région où est située la logique. La partie logique se trouve alors soumise à un potentiel non nul correspondant à l'équipotentielle $E''_1$.

On peut juger par comparaison avec les structures de l'art connu, et notamment celles décrites dans les articles cités plus haut, de la simplification apportée par l'invention au procédé de fabrication des commutateurs de puissance intelligents.

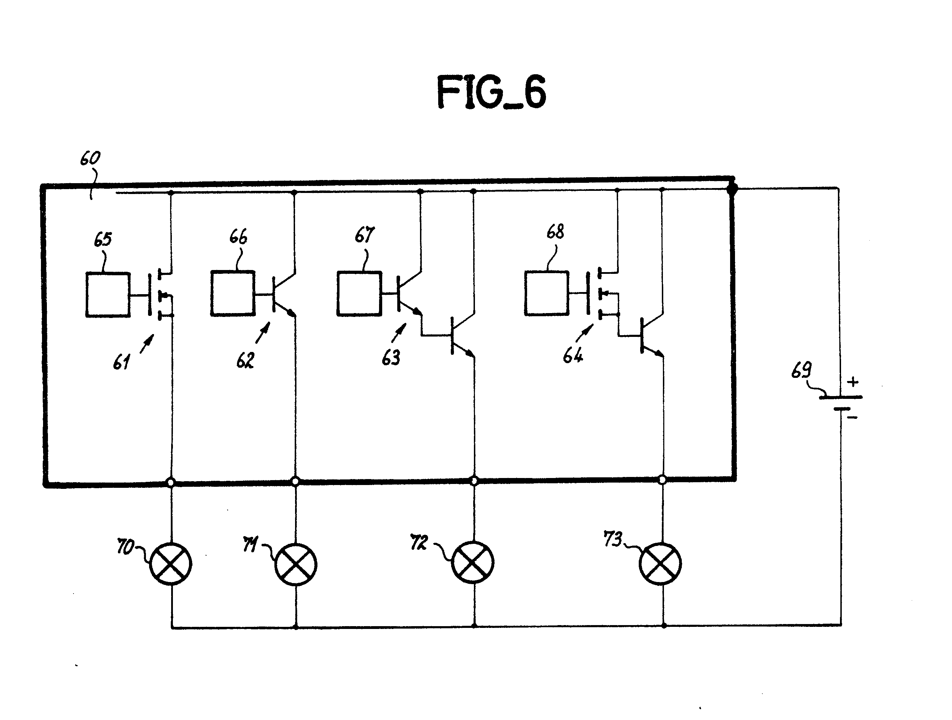

La résolution des équations de Poisson se fait en tenant compte d'un certain nombre de paramètres. La figure 4 est une vue de détail simplifiée d'une structure semiconductrice selon l'invention. Elle représente surtout l'espace compris entre deux caissons 21 et 22 de type P diffusés sur un substrat 20 de type N et destinés à l'élaboration de transistors. Une couche d'isolant 23 réunit les caissons 21 et 22 et il faudra tenir compte de son épaisseur, des charges qui y sont éventuellement incluses, de sa nature et en particulier de son mode d'obtention.

Dans certains cas, on peut être amené à utiliser des écrans électrostatiques conducteurs que l'on peut désigner sous l'appellation anglo-saxonne "field plate". La distance $d$ à considérer n'est plus alors celle séparant les caissons mais celle séparant les écrans conducteurs. La figure 5 représente une telle configuration. Sur cette figure, deux caissons 31 et 32 de type P diffusés sur un substrat 30 de type N sont réunis sur la face avant du substrat par une couche d'isolant 33 (oxyde de silicium $SiO_2$). On a représenté également deux électrodes en aluminium 34 et 35 appartenant aux transistors élaborés dans les caissons 31 et 32. Les électrodes 34 et 35 sont respectivement prolongées par les écrans ou "field plates" 36 et 37 par exemple en silicium polycristallin. La distance $d$ à considérer est alors celle séparant ces écrans 36 et 37 comme indiqué sur la figure 5. Les "field plates" peuvent aussi être utilisés pour prolonger les anneaux périphériques formés de caissons de type P.

L'invention permet également d'isoler entre elles plusieurs structures de puissance réalisées chacune dans des caissons distincts élaborés sur un même substrat, chacune de ces structures pouvant comporter une partie logique ou analogique de commande ou de protection. Cette configuration permet de réaliser des "commutateurs de puissance intelligents" à sorties multiples et qui travaillent en drain ou collecteur commun avec leur charge à la masse comme dans le cas du multiplexage automobile. La figure 6 représente une telle configuration. Sur un substrat 60 on a élaboré, à titre d'exemple, différents transistors de puissance, un VD MOS 61, un transistor bipolaire 62, un montage Darlington 63 à deux transistors bipolaires et un ensemble 64 constitué par un montage Darlington de deux transistors, l'un du type VD MOS et l'autre du type bipolaire. A ces transistors ou ensemble de transistors 61, 62, 63 et 64, sont associés des circuits logiques ou analogiques de commande et/ou de protection référencés respectivement 65, 66, 67 et 68. Ils autorisent le passage du courant fourni par la batterie 69 dans des charges 70, 71, 72 et 73. Tous les drains et collecteurs des différents transistors sont portés au potentiel du substrat.

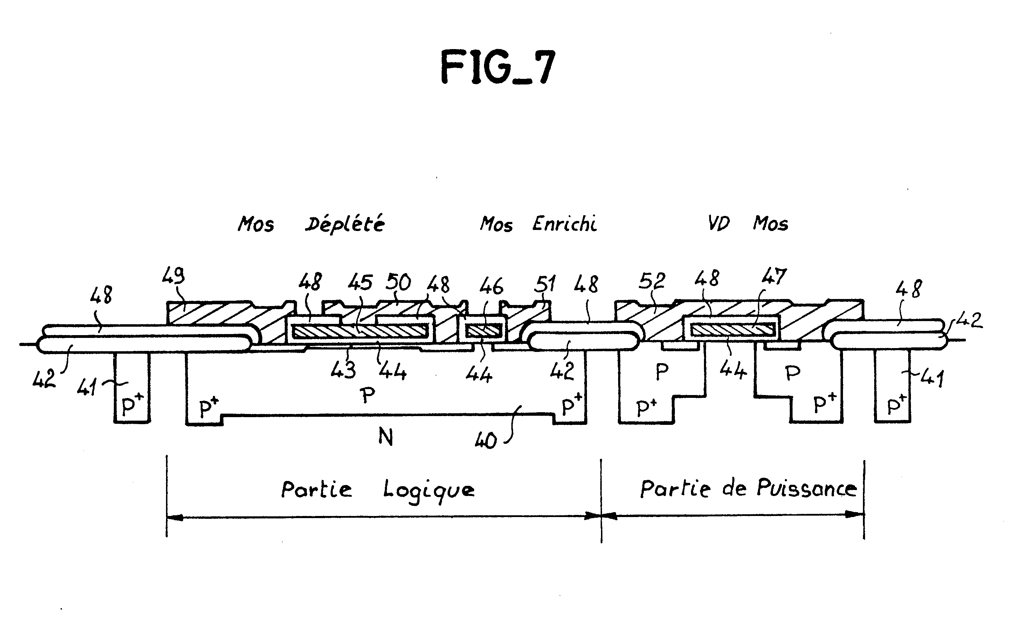

A titre d'exemple non limitatif, la suite de la description portera sur le procédé de fabrication d'un "commutateur de puissance intelligent" selon l'invention. Prises individuellement, les étapes du procédé font partie du domaine de l'art connu et seront exposées brièvement en association avec la figure 7 qui illustrera la description.

Le substrat de départ est une plaquette de silicium de type N+ sur laquelle on a épitaxié une couche de type N elle-même recouverte d'une mince couche d'oxyde. Grâce à une première opération de masquage, des fenêtres sont ouvertes dans l'oxyde en vue de réaliser la partie logique. Par implantation, on obtient un caisson 40 de type P suivi d'un recuit avec ré-oxydation superficielle. Un deuxième masque permet l'ouverture d'autres fenêtres en particulier pour l'obtention du transistor de puissance (VD MOS) et du ou des anneaux périphériques 41. Des caissons P+ sont alors implantés et la face avant du substrat subit alors une désoxydation totale suivie d'une réoxydation uniforme.

Le troisième masque permet de définir les zones actives de la structure semiconductrice. Entre ces zones, on procède alors à une oxydation localisée 42 du silicium. Le quatrième masque permet l'obtention d'un transistor MOS à déplétion dans la partie réservée à la logique par une implantation 43 de type N. Suivent une opération d'oxydation en vue d'obtenir l'oxyde de grille 44 des transistors des parties logique et de puissance et une opération de dépôt d'une couche de silicium polycristallin. Le cinquième masque permet la gravure du silicium polycristallin pour obtenir les grilles 45, 46 et 47 des transistors. Le sixième masque permet d'élaborer le canal P du VD MOS par implantation puis recuit. Le septième masque permet d'implanter la source du VD MOS ainsi que la source et le drain des transistors de la partie logique. Un recuit est effectué après l'implantation. Une couche 48 d'oxyde SiO₂ est déposée. La face arrière du substrat est alors rectifiée.

Le huitième masque permet la réalisation d'ouvertures dans l'oxyde pour assurer les prises de contact électrique. Une couche d'un alliage aluminium-silicium est uniformément déposée sur le substrat. Le neuvième masque permet la gravure de la couche d'alliage pour former les électrodes 49, 50, 51 et 52. Une couche de passivation est ensuite déposée. Enfin, le dixième masque permettra la gravure de la couche de passivation.

Il apparaît difficile de réaliser sur un même substrat plusieurs transistors de puissance puisque leur drain ou leur collecteur se trouvent en commun. Ceci est cependant réalisable en mettant par exemple tous les drains ou tous les collecteurs au plus de la tension d'alimentation.

Il entre dans le cadre de l'invention de réaliser la partie logique à partir de plusieurs caissons diffusés, les distances inter-caissons obéissant aux règles de l'invention. Ces caissons peuvent comprendre des transistors MOS de différents types (à canal N ou P, à enrichissement et à déplétion). Suivant le type de transistors MOS que comporte la partie logique, le nombre de masques pourra évidemment augmenter ou diminuer mais, en fin de compte, la structure selon l'invention sera plus économique que les structures de l'art connu.

## Revendications

1. Structure semiconductrice associant au moins un transistor de puissance et une partie logique ou analogique sur un même substrat semiconducteur (15), le transistor de puissance (10) étant du type MOS vertical à contact de drain sur la face arrière du substrat ou du type bipolaire vertical à contact de collecteur sur la face arrière du substrat ou une combinaison des deux types, la partie logique ou analogique étant du type à transistors MOS (11, 12) réalisée sur la face avant du substrat et destinée à commander la conduction du transistor de puissance, caractérisée en ce que :
   - le substrat est de type N+ fortement dopé,
   - le substrat est recouvert d'une ou de plusieurs couches épitaxiales ininterrompues de type N peu dopée,
   - des régions de type P sont diffusées à partir de la couche épitaxiale jusqu'à des profondeurs inférieures à celle de cette couche épitaxiale, ces régions définissant des caissons notamment pour des transistors MOS à canal N et des régions de canal ou de base pour le transistor de puissance,
   - la distance séparant deux régions de type P adjacentes étant inférieure à la somme des largeurs des zones de charge d'espace engendrées dans le substrat autour de ces régions de type P pour une tension entre région de type P et substrat qui risquerait de provoquer un claquage en surface ou en volume de la jonction existant entre la région de type P et le substrat et polarisée en inverse,
   - l'ensemble des régions P diffusées étant entouré par une région périphérique (13, 14) de type P diffusée, la distance séparant cette région périphérique de l'ensemble des régions P diffusées étant déterminée par les mêmes critères qui servent à définir la distance séparant deux régions de type P adjacentes.

2. Structure semiconductrice selon la revendication 1, caractérisée en ce qu'il est prévu des écrans électrostatiques conducteurs (36, 37) pour prolonger électrostatiquement certaines régions diffusées (31, 32).

3. Structure semiconductrice selon l'une des revendications 1 ou 2, caractérisée en ce que la partie logique ou analogique comprend un transistor MOS déplété et un transistor MOS enrichi.

4. Structure semiconductrice selon l'une quelconque des revendications 1 à 3, caractérisée en ce qu'elle comprend plusieurs transistors de puissance logés dans des caissons P distincts.

**FIG_1**

**FIG_4**

**FIG_5**

FIG_2

FIG_3

# FIG_6

# FIG_7

Mos  Déplété          Mos  Enrichi          VD  Mos

Partie   Logique                    Partie de Puissance

0236200

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | EP-A-0 129 362  (TOSHIBA)<br>* Figure 3; page 6, lignes 7-37 *<br>--- | 1 | H 01 L  29/06<br>H 01 L  27/02 |
| Y | RADIO FERNSEHEN ELEKTRONIK, vol. 28, no. 7, juillet 1979, pages 447-449, Berlin, DE; C. KÜHNEL: "Bipolare und MOS-Bauelemente auf einem Chip"<br>* Figure 2; page 447, colonne  du milieu, paragraphe 2 *<br>--- | 1 | |
| A | SOLID STATE ELECTRONICS, vol. 27, no. 11, novembre 1984, pages 1021-1027, Pergamon Press Ltd, New York, US; K.R. WHIGHT et al.: "Numerical analysis of multiple field limiting ring systems"<br>*  Page  1023, colonne de gauche, dernier  paragraphe;  page  1025, paragraphe 3.4; figure 9 *<br>--- | 1 | |
| A | ALTA FREQUENZA, vol. 39, no. 2, février 1970, pages 126-132, Milano, IT; F. CONTI et al.: "Breakdown voltages and design of rings in M.G.R. devices"<br>* Figures 10,11,3 *<br>---          -/- | 1 | |

DOMAINES TECHNIQUES RECHERCHES (Int. Cl.4)

H 01 L

Le présent rapport de recherche a été établi pour toutes les revendications

| Lieu de la recherche | Date d'achèvement de la recherche | Examinateur |
|---|---|---|
| LA HAYE | 02-06-1987 | MACHEK, J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82

## DOCUMENTS CONSIDERES COMME PERTINENTS

Page 2

| Catégorie | Citation du document avec indication, en cas de besoin, des parties pertinentes | Revendication concernée | CLASSEMENT DE LA DEMANDE (Int. Cl.4) |
|---|---|---|---|
| A | IEEE TRANSACTIONS ON ELECTRON DEVICES, vol. ED-31, no. 12, Décembre 1984, pages 1769-1773, IEEE, New York, US; M.N. DARWISH et al.: "Optimization of breakdown voltage and on-resistance of VDMOS transistors" * Figures 2,3,7 * | 1,2 | |
| A | EP-A-0 104 454 (HITACHI) * Figures 1b,2b,3b,4b; page 12, ligne 1 - page 3, ligne 4 * | 1,2 | |
| A | 1982 SID INTERNATIONAL SYMPOSIUM, DIGEST OF TECHNICAL PAPERS, mai 1982, pages 253-254, 1ère édition, Lewis Winner, Coral Gables, US; R.A: BLANCHARD: "High-voltage ICs for electroluminescent panels"Figures 2,3 | 3,4 | DOMAINES TECHNIQUES RECHERCHES (Int. Cl.4) |

Le présent rapport de recherche a été établi pour toutes les revendications

| Lieu de la recherche | Date d'achèvement de la recherche | Examinateur |
|---|---|---|
| LA HAYE | 02-06-1987 | MACHEK, J. |